# EUROPEAN PATENT SPECIFICATION

(11) **EP 1 748 613 B1**
(45) Date of publication and mention of the grant of the patent: **11.03.2009**
(21) Application number: 06251308.0
(22) Date of filing: 13.03.2006
(51) Int. Cl.: H04L 27/26, H04N 5/44, H04B 1/10, H03J 5/00

(54) **Demodulator**
Demodulator
Démodulateur

(30) Priority: 27.07.2005 JP 2005217216
(43) Date of publication of application: 31.01.2007
(73) Proprietor: FUJITSU LIMITED, Kawasaki-shi, Kanagawa 211-8588 (JP)
(72) Inventor: Hamaminato, Makoto, Fujitsu Limited, Kawasaki-shi Kanagawa 211-8588 (JP)
(74) Representative: Mohun, Stephen John

(56) References cited:
- WO-A-00/11813
- US-A1- 2002 157 106
- US-A1- 2003 224 731

## Description

### BACKGROUND OF THE INVENTION

### [Field of the Invention]

The present invention relates to a demodulator.

### [Description of the Related Art]

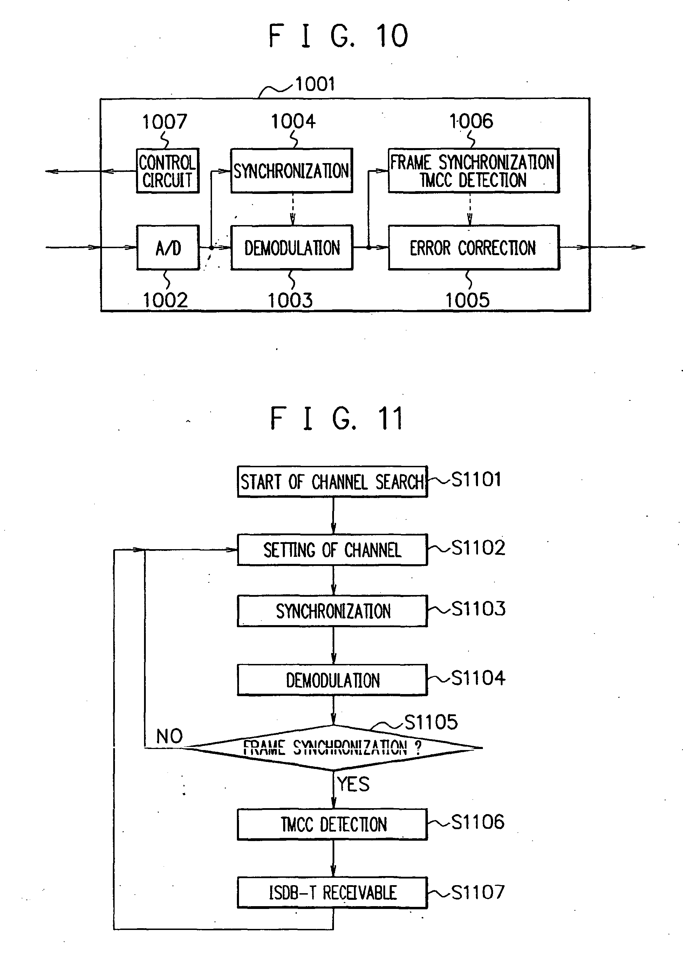

Fig. 10 is a diagram showing a constitutional example of an orthogonal frequency division multiplex (OFDM) demodulator 1001. In a television receiving apparatus for-terrestrial digital broadcast, the OFDM demodulator 1001 is provided. The OFDM demodulator 1001 includes an A/D conversion unit 1002, a demodulation processing unit 1003, a synchronization processing unit 1004, an error correction processing unit 1005; a frame synchronization processing and TMCC detection unit 1006, and a control circuit 1007.

Fig. 11 is a flowchart showing a processing of a channel search. The channel search is the processing to search a receivable channel, and it is enough that the processing is performed once, for example, at a time of installment of the television receiving apparatus.

In a step S1101, when a start of the channel search is instructed, the following processings are performed. In a step S1102, the control circuit 1007 instructs an outside tuner which channel to receive. For example, the control circuit 1007 instructs receiving of Channel One. Then, the tuner outputs a signal of that channel to the A/D conversion unit 1002. The A/D conversion unit 1002 converts an input signal from an analog format to a digital format, and outputs to the synchronization processing unit 1004 and the demodulation processing unit 1003.

Next, in a step S1103, the synchronization processing unit 1004 performs a synchronization processing based on an output signal of the A/D conversion unit 1002. Next, in a step S1104, the - demodulation processing unit 1003 performs a demodulation processing at a predetermined timing based on output signals of the A/D conversion unit 1002 and the synchronization processing unit 1004, and outputs to the frame synchronization processing and TMCC detection unit 1006, and the error correction processing unit 1005. The demodulation processing includes an OFDM demodulation and a phase demodulation.

Next, in a step S1105, the frame synchronization processing unit 1006 performs a frame synchronization processing based on an output signal of the demodulation processing unit 1003. Specifically, the frame synchronization processing unit 1006 detects a synchronizing signal (synchronizing byte) in the output signal of the demodulation processing unit 1003. When the synchronizing signal cannot be detected, that channel is judged to be unreceivable and a process returns to the step S1002. In the step S1002, a next channel (for example, Channel Two) is set, and the same processings are repeated.

When the synchronizing signal is detected, the frame synchronization processing is performed and the process proceeds to a step S1106. In the step S1106, the TMCC detection unit 1006 detects TMCC (Transmission and Multiplexing Configuration Control) information in the output signal of the demodulation processing unit 1003. The TMCC information includes information of a phase (carrier) modulation scheme.

Next, in a step S1107, it is judged that an ISDB-T (Integrated Services Digital Broadcasting-Terrestrial) signal of that channel is receivable. The ISDB-T signal is a receive signal by a standard of the terrestrial digital broadcast, and adopts an OFDM modulation scheme. Subsequently, the process returns to the step S1002. In the step S1002, a next channel (for example, Channel Two) is set and the same processings are repeated. By repeating the above processings for all the channels, receivable channels can be searched.

At a time of a normal reception, when a user designates a channel, the tuner outputs an ISDB-T signal of the designated channel to the OFDM demodulator 1001. Subsequently, the processings from steps S1103 to S1106 in Fig. 11 are performed. Then, the error correction processing unit 1005 performs an error correction based on the output signals of the demodulation processing unit 1003, and the frame synchronization processing and TMCC detection unit 1006. Specifically, the error correction processing unit 1005 error-corrects the output signal of the demodulation processing unit 1003 using the TMCC information detected by the TMCC detection unit 1006, and outputs an MPEG 2 transport stream. The MPEG 2 transport stream is decoded by an MPEG 2 decoder, and image and audio are reproduced.

In below-sated Patent Document 1, there is described a broadcast signal identification apparatus which sets a certain band centering on a picture frequency of an NTSC signal, measures a peak value of electric power within this certain band and an electric power value of the entire band, and judges whether a broadcast signal of a received channel is an analog broadcast wave or a digital broadcast wave.

In below-stated Patent Document 2, there is described a broadcast reception apparatus which tentatively judges presence/absence of digital broadcast in a selected channel by whether or not a TMCC signal is obtained by a demodulation processing, and, in a state that presence of the digital broadcast is tentatively judged, judges presence/absence of the digital broadcast in the selected channel by whether or not section information (NIT) is obtained by a selected channel information extraction processing.

In below-stated Patent Document 3, there is described a terrestrial digital broadcast reception apparatus which, based on a detection signal detected by an analog broadcast wave detection means, can skip a search in a corresponding channel in a front end unit for digital broadcast, when the apparatus performs a channel search which is to be performed at a time of installation of the terrestrial digital broadcast reception apparatus.

In below-stated Patent Document 4, there is described a reception apparatus in which an OFDM receiver of ISDB-T standard presets TMCC information to correspond to respective broadcast stations in a memory in advance, and when a user selects a broadcast station, a control circuit reads out the TMCC information corresponding to that broadcast station from the memory, then simultaneously with a start of a reception operation, the above read-out TMCC information is given to the respective circuits, to carry out setting of, for example, a guard interval, a carrier modulation scheme, and so on.

[Patent Document 1] Japanese Patent Application Laid-open No. 2003-234975

[Patent Document 2] Japanese Patent Application Laid-open No. 2004-363806

[Patent Document 3] Japanese Patent Application Laid-open No. 2003-69907

[Patent Document 4] Japanese Patent Application Laid-open No. 2001-292121

However, in Fig. 11, since it is necessary to perform a synchronization processing of a step S1103, a demodulation processing of a step S1104, and a frame synchronization processing of a step S1105 for every channel after the channel is set, search time per one channel becomes long. Additionally, misjudgment may occur in a channel search due to influence of a NTSC (National Television Standard Committee) signal or the like of analog television broadcast.

US 2002/157106 A1 describes a receiver system for rapidly selecting a desired downstream receiver channel from the broad cable frequency bandwidth. The system first makes a coarse scan of the signal spectrum to identify the most probable frequency zones, and subsequently makes a high resolution scan of the selected frequency zones to identify the desired channel.

US 2003/224731 A1 describes a radio communication method or system for transmitting part of the control signal addresses to a terminal station from a base station by means of a narrow-band carrier which is narrower than the band of multi-carrier signal and is arranged in the vicinity of the frequency band used for information transmission, in the case where a plurality of frequency bands for information transmission exist continuously. It may be modified such that part of the control signal addressed to the terminal station, which is transmitted from the base station, is transmitted by means of one or more subcarriers in the band of the multi-carrier signal. A radio communication method for exchanging information between a base station and a terminal station in the frame period by means of multi-carrier signals due to OFDM modulation scheme, in which the transmission of part of the control signal addressed from the base station to the terminal station is accomplished by means of the specific position in the frame period. The foregoing method reduces loads on the base station or terminal station when control signals are transmitted from the base station to the terminal (mobile) station in the OFDM communication system.

The present invention is defined in the attached independent claims, to which reference should now be made. Further, preferred features may be found in the sub-claims appended thereto.

### SUMMARY OF THE INVENTION

The present invention is objected to prevent misjudgment in a channel search and/or to shorten channel search time.

A demodulator of the present invention includes: a filter filtering a signal based on pass frequency bands changed at a time of a channel search and at a time of normal reception; and a demodulation processing unit performing an orthogonal frequency division multiplex demodulation based on the filtered signal.

Also, a demodulator of the present invention includes: a synchronization processing unit performing a synchronization processing based on an input signal; and a demodulation processing unit performing an orthogonal frequency division multiplex demodulation based on the synchronization processed signal, wherein the synchronization processing unit calculates a correlation value of a signal being a delayed input signal and the input signal, and performs the synchronization processing when the correlation value satisfies a condition.

Also, a demodulator of the present invention includes: a synchronization processing unit performing a synchronization processing based on an input signal; and a demodulation processing unit performing an orthogonal frequency division multiplex demodulation based on the synchronization processed signal, wherein the demodulation processing unit performs the orthogonal frequency division multiplex demodulation when frequency allocation of a reference signal in the input signal satisfies a condition.

### BRIEF DESCRIPTION OF THE DRAWINGS

Fig. 1 is a diagram showing a constitutional example of a television receiving apparatus according to an embodiment of the present invention;
Fig. 2 is a flowchart showing a processing of a channel search;
Fig. 3 is a diagram of a frequency spectrum showing pass frequency bands of a FIR type digital filter;
Fig. 4 is a diagram showing a constitutional example of a part of a synchronization processing unit;
Fig. 5 is a diagram showing one symbol amounts of an input signal and a delay signal;
Fig. 6 is a diagram showing a constitutional example of a part of a demodulation processing unit;
Fig. 7 is a diagram showing a constitutional example of a part of a frame synchronization processing unit;
Fig. 8 is a diagram showing a constitutional example of a memory recording channel information and TMCC information;
Fig. 9 is a flowchart showing a processing of a normal reception;
Fig. 10 is a diagram showing a constitutional example of an OFDM demodulator; and
Fig. 11 is a flowchart showing a processing of a channel search.

### DETAILED DESCRIPTION OF THE PREFERRED EMBODIMENTS

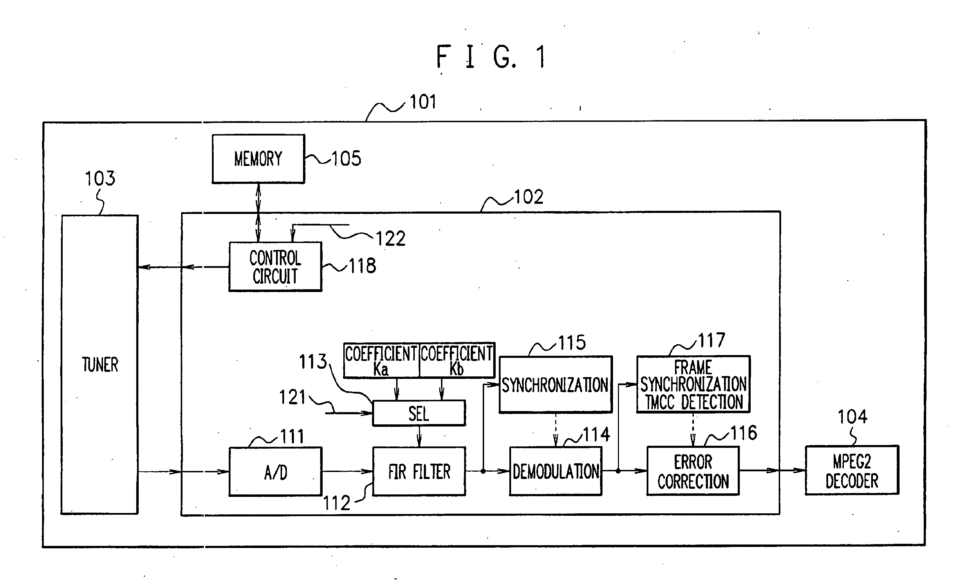

Fig. 1 is a diagram showing a constitutional example of a television receiving apparatus 101 according to an embodiment of the present invention. The television receiving apparatus 101 includes an OFDM demodulator 102, a tuner 103, an MPEG 2 decoder 104, and a memory 105, and can receive an ISDB-T signal of terrestrial digital broadcast. The OFDM demodulator 102 includes an A/D conversion unit 111, a FIR (Finite Impulse Response) type digital filter 112, a selector 113, a demodulation processing unit 114, a synchronization processing unit 115, an error correction processing unit 116, a frame synchronization processing and TMCC detection unit 117, and a control circuit 118.

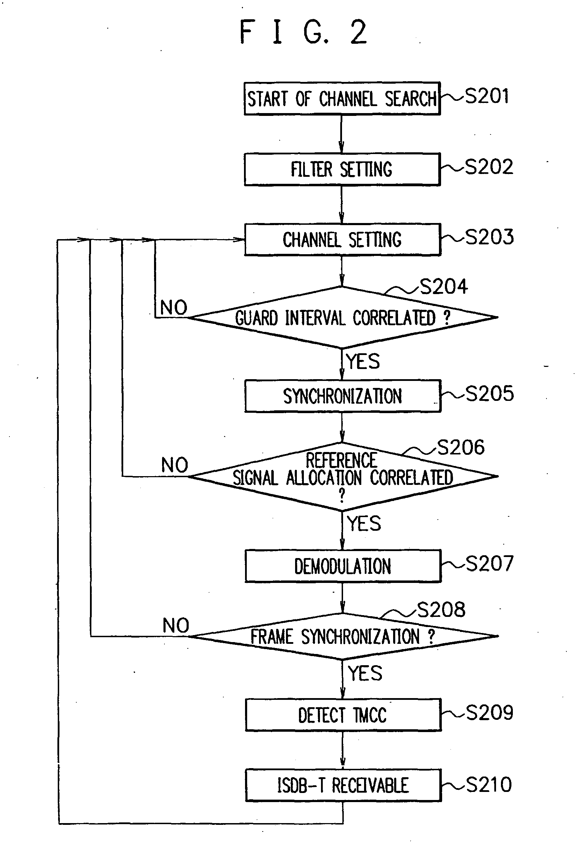

Fig. 2 is a flowchart showing a processing of a channel search. The channel search is the processing to search a receivable channel, and it is enough that the processing is performed once, for example, at a time of installation of the television receiving apparatus 101.

In a step S201, when a start of the channel search is instructed, the following processings are performed. In a step S202, filter setting is carried out. A control signal 121 designates either a channel search mode or a normal reception mode. The selector 113 sets a filter coefficient Kb to the FIR type digital filter 112 when the control signal 121 designates the channel search mode, and sets a filter coefficient Ka to the FIR type digital filter 112 when the control signal 121 designates the normal reception mode. At a time of the channel search, the filter coefficient Ka is set to the FIR type digital filter 112, since the channel search mode is designated.

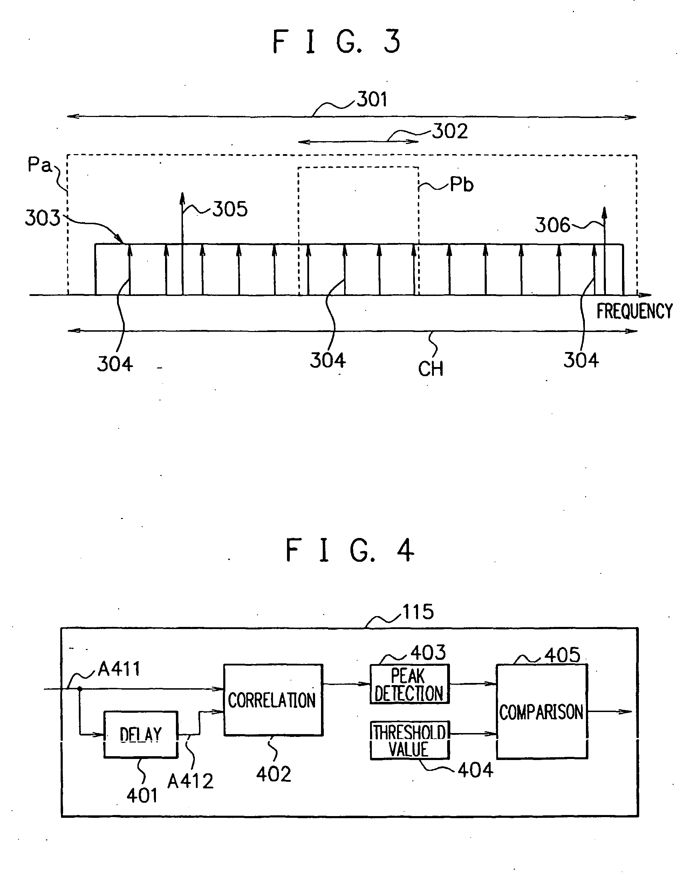

Fig.3 is a diagram of a frequency spectrum showing pass frequency bands of the FIR type digital filter 112. Presently, both terrestrial digital broadcast and terrestrial analog broadcast exist. An ISDB-T signal 303 is a terrestrial digital broadcast signal, while NTSC signals 305 and 306 are terrestrial analog broadcast signals. The NTSC signal 305 is a video carrier, while the NTSC signal 306 is a sound carrier. The ISDB-T signal 303 is a signal to be demodulated and has a plurality of TMCC signals 304 at specified frequency intervals (periodically).

As for the ISDB-T signal 303, a frequency bandwidth of one channel CH is 6 MHz. At the time of the normal reception, the selector 113 sets the filter coefficient Ka to the FIR type digital filter 112. Then, the FIR type digital filter 112, to which a pass frequency band 301 is set, passes only a signal Ps for one channel CH.

The frequency bands of the ISDB-T signal 303 and NTSC signals 305, 306 are overlapped. At a time of a channel search of the ISDB-T signal 303, the NTSC signals 305 and 306 become obstacles, and cause misjudgment in the channel search. Therefore, at the time of the channel search, the selector 113 sets the filter coefficient Kb to the FIR type digital filter 112. Then, the FIR type digital filter 112, to which a pass frequency band 302 is set, passes only a signal Pb. Since a single or a plurality of TMCC signal(s) 304 is (are) included in the signal Pb, it is possible to perform the channel search based on the signal Pb. By removing (attenuating) the NTSC signals 305 and 306 by the FIR type digital filter 112 and performing the channel search based on the signal Pb, misjudgment in the channel search can be prevented. -

The FIR type digital filter 112 filters a signal based on the pass frequency bands changed at the time of the channel search and at the time of the normal reception. Additionally, the FIR type digital filter 112 can reduce circuit scale since the FIR type digital filter 112 serves as the filter for both the normal reception and the channel search.

Next, in a step S203 of Fig. 2, the control circuit 118 instructs the tuner 103 which channel to receive. For example, the control circuit 118 instructs receiving of Channel One. Then, the tuner 103 outputs an ISDB-T signal of that channel to the A/D conversion unit 111. The A/D conversion unit 111 converts an input signal from an analog format to a digital format, and outputs to the FIR type digital filter 112. The FIR type digital filter 112, to which the pass frequency band 302 is set, passes only the signal Pb by filtering the input signals, and then outputs to the synchronization processing unit 115 and the demodulation processing unit 114.

Next, in a step S204, the synchronization processing unit 115 judges whether or not a correlation of guard intervals exists. If the correlation exists, a process proceeds to a step S205, and if the correlation does not exist, that channel is judged to be unreceivable and the process returns to the step S203. In the step S203, a next channel (for example, Channel Two) is set, and the same processings are repeated. As stated above, if the correlation does not exist, the search processing of the next channel can be performed without the synchronization processing of the step S205, demodulation processing of a step S207 and a frame synchronization processing of a step S208 being performed, so that channel search time can be shortened. Hereinafter, a detailed processing of the synchronization processing unit 115 will be described.

Fig. 4 is a diagram showing a constitutional example of a part of the synchronization processing unit 115. An input signal A411 is an output signal of the FIR type digital filter 112. A delay processing unit 401 outputs a signal A412 made by delaying the input signal A411 by one symbol.

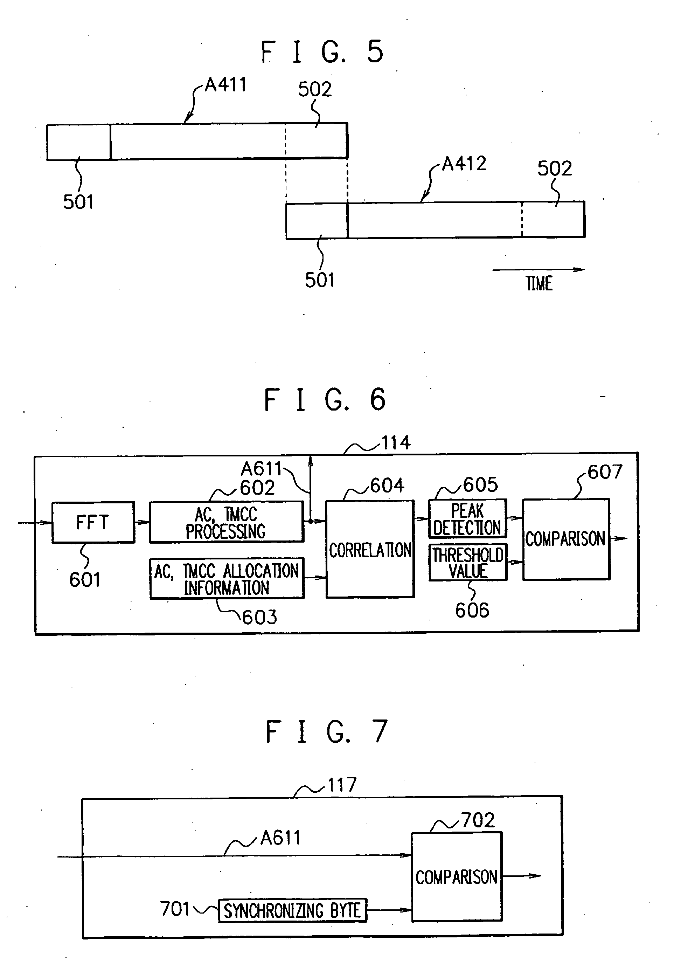

Fig. 5 is a diagram showing one symbol amounts of the input signal A411 and the delay signal A412. Receive signals include a delay signal (signal arriving after reflected on a building or the like) in addition to a direct signal. In order to separate the direct signal and the delay signal, in the ISDB-T signal A411, a rear end portion 502 of the symbol is copied and made to be a front end portion 501. Making a signal into cyclic construction as described above is the guard interval. Therefore, the rear end portion 502 of the input signal A411 and the front end portion 501 of the delay signal A412 are the same, and a correlation value of the both in this guard interval period is high. If the correlation value is high, it is highly possible that the ISDB-T signal of that channel is receivable, and if the correlation value is low, the ISDB-T signal of that channel can be judged to be unreceivable.

In Fig. 4, a correlation processing unit 402 calculates a correlation value of the input signal A411 and the delay signal A412 in the guard interval period. A peak detection unit 403 takes a moving average (integral) of the above correlation value and detects its peak value. A comparison unit 405 compares the peak value and a threshold value 404, and outputs a comparison result. When the peak value exceeds the threshold value 404, a correlation is judged to exist and the process proceeds to the step S205 of Fig. 2. When the peak value is less than or equal to the threshold value 404, the correlation is judged not to exist and the process returns to the step S203 of Fig. 2.

In the step S205, the synchronization processing unit 115 performs the synchronization processing based on the output signal of the FIR type digital filter 112.

Next, in a step S206, the demodulation processing unit 114 judges the number of reference signals in the input signals and whether or not frequency allocation has a correlation with a predetermined one. The reference signal is a TMCC signal and/or an AC (Auxiliary Channel) signal. The A/C signal is a preliminary signal. If the correlation exists, the process proceeds to the step S207, and if the correlation does not exist, that channel is judged to be unreceivable and the process returns to the step S203. In the step S203, the next channel (for example, Channel Two) is set and the same processings are repeated. As stated above, if the correlation does not exist, a search processing of the next channel can be performed without the demodulation processing of the step S207 and the frame synchronization processing in the step S208 being performed, so that channel search time can be shortened. Hereinafter, a detailed processing of the demodulation processing unit 114 will be described.

Fig. 6 is a diagram showing a constitutional example of a part of the demodulation processing unit 114. A fast Fourier transform (FFT) processing unit 601 transforms an input signal into a frequency component signal by FFT, and outputs to an AC and TMCC processing unit 602. For example, the signal Pb on a frequency axis of Fig. 3 is obtained. The AC and TMCC processing unit 602 detects the AC signal and TMCC signal A611 in the input signal. A correlation processing unit 604 calculates a correlation value of the number and frequency allocation of the AC signal and TMCC signal A611, and the number and frequency allocation information 603 of predetermined AC signal and TMCC signal. A peak detection unit 605 takes a moving average (integral) of the above correlation value and detects its peak value. A comparison unit 607 compares the peak value and a threshold value 606, and outputs a comparison result. When the peak value exceeds the threshold value 606, a correlation is judged to exist and the process proceeds to the step S207 of Fig. 2. When the peak value is less than or equal to the threshold value 606, the correlation is judged not to exist and the process returns to the step S203 of Fig. 2.

In the step S207, the demodulation processing unit 114 performs the demodulation processing based on output signals of the FIR type digital filter 112 and the synchronization processing unit 115 at a predetermined timing, and outputs to the frame synchronization processing and TMCC detection unit 117 and the error correction processing unit 116. The demodulation processing includes an OFDM demodulation and a phase demodulation.

Next, in the step S208, the frame synchronization processing unit 117 performs a frame synchronization processing based on an output signal of the demodulation processing unit 114. One frame consists of 204 symbols. Specifically, the frame synchronization processing unit 117 detects a synchronizing signal (synchronizing byte) in the output signals of the demodulation processing unit 114. When the synchronizing signal cannot be detected, that channel is judged to be unreceivable and the process returns to the step S203. In the step S203, the next channel (for example, Channel Two) is set, and the same processings are repeated. When the synchronizing signal is detected, the frame synchronization processing is performed and the process proceeds to a step S209. Hereinafter, a detailed processing of the frame synchronization processing unit 117 will be described.

Fig. 7 is a diagram showing a constitutional example of a part of the frame synchronization processing unit 117. Input signals A611 are the AC signal and TMCC signal which the AC and TMCC processing unit 602 of Fig. 6 outputs. A comparison unit 702 compares whether or not the synchronizing signal (synchronizing byte) in the AC signal and TMCC signal A611, and a predetermined synchronizing signal (synchronizing byte) 701 have the same values, and outputs a comparison result thereof. If the values are the same, it is judged that the synchronizing signal is detected and the process proceeds to the step S209 of Fig. 2. When the values are not the same, it is judged that the synchronizing signal cannot be detected and the process returns to the step S203 of Fig. 2.

In the step S209, the TMCC detection unit 117 detects TMCC information in a TMCC signal of the output signal of the demodulation processing unit 114. The TMCC information includes information of a phase (carrier) modulation scheme.

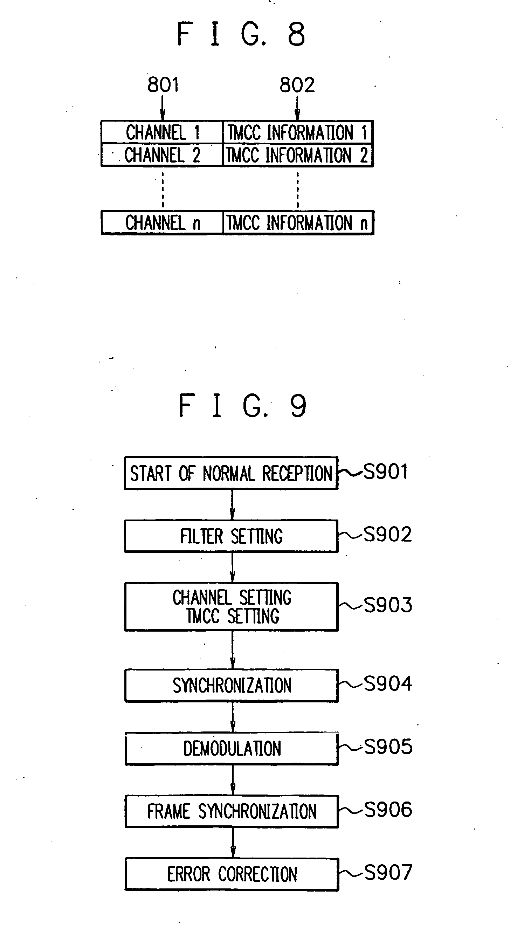

Next, in a step S210, an ISDB-T signal of that channel is judged to be receivable. The ISDB-T signal is a receive signal by a standard of terrestrial digital broadcast and adopts an OFDM modulation scheme. The control circuit 118, when a signal 122 to indicate receivablenss is inputted, performs a recording control to the memory 105 that the channel is receivable. The control circuit 118 also carries out a control such that channel information (number) 801 and TMCC information 802 are recorded correspondingly in the memory 105, as shown in Fig. 8. The TMCC information 802 is the TMCC information detected in the step S209.

Subsequently, the profess returns to the step S203. In the step S203, the next channel (for example, Channel Two) is set and the same processings are repeated. By repeating the above-described proceesings for all channels, receivable channels can be searched.

In the steps S204, S206 and S208, when the channel is judged to be unreceivable, the control circuit 118 inputs a control signal 122 indicating to that effect and can perform a recording control to the memory 105 that the channel is unreceivable. Judgment result signals 122 of the steps S204, S206 and S208 are respectively used for channel control of the tuner 103 by the control circuit 118.

Fig. 9 is a flowchart showing a processing of the normal reception. After the above-described channel search is finished, the ISDB-T signal is received by the normal reception, and image and audio can be reproduced.

In the step S901, when a start of the normal reception is instructed, the following processings are performed. In a step S902, filter setting is carried out. The selector 113 sets the filter coefficient Ka to the FIR type digital filter 112. Then, the FIR type digital filter 112, to which the pass frequency band 301 is set, passes only the signal Pa.

Next, in a step S903, when the user designates a channel, the tuner 103 outputs an ISDB-T signal of the designated channel to the A/D conversion unit 111 of the OFDM demodulator 102. The A/D conversion unit 111 converts an input signal from an analog format to a digital format, and outputs to the FIR type digital filter 112. The FIR type digital filter 112; to which the pass frequency band 301 is set, passes only the signal Pa by filtering input signals, and outputs to the synchronization processing unit 115 and the demodulation processing unit 114.

Next, TMCC setting is carried out. The control circuit 118 reads out TMCC information 802 (Fig. 8) corresponding to the channel from the memory 105 and set the information. Specifically, the TMCC detection unit 117 can set the TMCC information 802 which has been read out to the error correction processing unit 116.

Next, in a step S904, the same synchronization processing as that of the step S205 of Fig. 2 is performed. Next, in a step S905, the same demodulation processing as that of the step S207 is performed. Next, in a step S906, the same frame synchronization processing as that of the step S208 is performed.

Next, in a step S907, the error correction processing unit 116 performs error correction based on output signals of the demodulation processing unit 114 and the frame synchronization processing and TMCC detection unit 117. Specifically, the error correction processing unit 116 error-corrects the output signal of the demodulation processing unit 114 using the TMCC information 802 set in the step S903, and outputs an MPEG 2 transport stream to the MPEG 2 decoder 104. The MPEG 2 decoder 104 decodes the MPEG 2 transport stream, and image and audio is reproduced.

Incidentally, normally, between the steps S906 and S907, the TMCC detection processing of the step S209 of Fig. 2 is performed. Subsequently, in the step S907, the TMCC information detected there is used to perform the error correction. However, in the present embodiment, since the TMCC setting is carried out in the step S903, the TMCC detection processing between the steps S906 and S907 becomes unnecessary. Therefore, the normal reception processing can be made simple and fast. The TMCC detection unit 117 detects TMCC information in the input signal at the time of the channel search of Fig. 2, and does not detect TMCC information at the time of the normal reception. At the time of the normal reception, the TMCC information in the memory 105 is used.

As stated above, according to the present embodiment, since the unnecessary NTSC signals 305, 306 can be removed by the filter 112, misjudgment in the channel search can be prevented. The synchronization processing of the step S205 and/or the demodulation of the step S207 is (are) carried out only when judgments in the steps S204 and S206 of Fig.2 satisfy predetermined conditions. When the predetermined condition is not satisfied, the above-described synchronization processing and/or demodulation being (an) additional processing(s) can be omitted, and channel search time can be drastically shortened.

As for the judgments in the steps S204 and S206 of Fig. 2, onl-y either one of them can be carried out. Also in that case, an effect of shortened channel search time can be obtained.

Since the unnecessary signals such as the NTSC signal can be removed by the filter, misjudgment in the channel search can be prevented. Additionally, channel search time can be shortened by performing the synchronization processing or demodulation when the predetermined condition is satisfied.

The above embodiments are to be considered in all respects illustrative and no restrictive, and all changes which come within the meaning and range of equivalence of the claims are therefore intended to be embraced therein. The invention may be embodied in other specific forms without departing from the essential characteristics thereof.

## Claims

1. A demodulator (102) comprising:
a filter (112) for filtering a signal based on pass frequency bands changed at a time of a channel search and at a time of a normal reception; and
a demodulation processing unit (114) for performing an orthogonal frequency division multiplex demodulation based on the filtered signal, **characterised by** further comprising:
a synchronization processing unit (115) for performing a synchronization processing based on the filtered signal;
a frame synchronization processing unit (117) for performing a detection of a synchronizing signal based on the demodulated signal; and
a TMCC detecting unit (117) for detecting TMCC Transmission and Multiplexing Configuration Control information based on the demodulated signal when the synchronizing signal is detected,
wherein said demodulation processing unit (114) is arranged to perform the orthogonal frequency division multiplex demodulation based on the synchronization processed signal, and
wherein said demodulation processing unit (114) is arranged to perform the orthogonal frequency division multiplex demodulation after the synchronization processing when frequency allocation of a reference signal in the filtered signal satisfies a condition.

2. The demodulator according to claim 1,
wherein the TMCC information includes information of a phase modulation scheme.

3. The demodulator according to claim 2,
wherein said synchronization processing unit is arranged to calculate a correlation value of a signal being a delayed input signal and the input signal, and to perform the synchronization processing when the correlation value satisfies a condition.

4. The demodulator according to claim 1,
wherein the reference signal is a TMCC signal and/or an AC Auxiliary Channel signal.

5. The demodulator according to claim 4,
further comprising a recording control unit for performing a control such that the detected TMCC information and channel information are recorded correspondingly.

6. The modulator according to claim 5,
further comprising an error correction processing unit for error-correcting the demodulated signal based on the detected TMCC information.

7. The demodulator according to claim 6,
wherein said TMCC detection unit is arranged to detect TMCC information at the time of the channel search and not to detect TMCC information at the time of the normal reception, and
wherein said error correction processing unit is arranged to perform an error correction based on the recorded TMCC information, at the time of the normal reception.

8. The demodulator according to claim 4,
further comprising a recording control unit for performing a control such that the detected TMCC information and channel information are recorded correspondingly.

9. The demodulator according to claim 8,
further comprising an error correction processing unit for error-correcting the demodulated signal based on the detected TMCC information.

10. The demodulator according to claim 9,
wherein said TMCC detection unit is arranged to detect TMCC information at the time of the channel search and not to detect TMCC information at the time of the normal reception, and
wherein said error correction processing unit is arranged to perform the error correction based on the recorded TMCC information, at the time of the normal reception.

11. A demodulator (102) comprising:
a synchronization processing unit (115) for performing a synchronization processing based on an input signal; and
a demodulation processing unit (114) for performing an orthogonal frequency division multiplex demodulation based on the synchronization processed signal, and
wherein said demodulation processing unit is arranged to perform the orthogonal frequency division multiple demodulation when frequency allocation of a reference signal in the input signal satisfies a condition.

12. The demodulator according to claim 11,
wherein the reference signal is a TMCC signal and/or an AC Auxiliary Channel signal.

## Patentansprüche

1. Demodulator (102) mit:
einem Filter (112) zum Filtern eines Signals auf der Basis von Durchlassfrequenzbändern, die zu einer Zeit einer Kanalsuche und zu einer Zeit eines normalen Empfangs verändert werden; und
einer Demodulationsverarbeitungseinheit (114) zum Ausführen einer orthogonalen Frequenzmultiplex-Demodulation auf der Basis des gefilterten Signals, **dadurch gekennzeichnet, dass** er ferner umfasst:
eine Synchronisationsverarbeitungseinheit (115) zum Ausführen einer Synchronisationsverarbeitung auf der Basis des gefilterten Signals;
eine Rahmensynchronisationsverarbeitungseinheit (117) zum Ausführen einer Detektion eines Synchronisiersignals auf der Basis des demodulierten Signals; und
eine TMCC-Detektionseinheit (117) zum Detektieren von TMCC-(Transmission and Multiplex Configuration Control)-Informationen auf der Basis des demodulierten Signals, wenn das Synchronisiersignal detektiert wird,
bei dem die Demodulationsverarbeitungseinheit (114) angeordnet ist, um die orthogonale Frequenzmultiplex-Demodulation auf der Basis des Synchronisationsverarbeitungssignals auszuführen, und
bei dem die Demodulationsverarbeitungseinheit (114) angeordnet ist, um die orthogonale Frequenzmultiplex-Demodulation nach der Synchronisationsverarbeitung auszuführen, wenn die Frequenzzuordnung eines Referenzsignals in dem gefilterten Signal eine Bedingung erfüllt.

2. Demodulator nach Anspruch 1,
bei dem die TMCC-Informationen Informationen über ein Phasenmodulationsschema enthalten.

3. Demodulator nach Anspruch 2,
bei dem die Synchronisationsverarbeitungseinheit angeordnet ist, um einen Korrelationswert eines Signals, das ein verzögertes Eingangssignal ist, und des Eingangssignals zu berechnen und die Synchronisationsverarbeitung auszuführen, wenn der Korrelationswert eine Bedingung erfüllt.

4. Demodulator nach Anspruch 1,
bei dem das Referenzsignal ein TMCC-Signal und/oder ein AC-(Auxialiary Channel)-Signal ist.

5. Demodulator nach Anspruch 4,
ferner mit einer Aufzeichnungssteuereinheit zum Ausführen solch einer Steuerung, dass die detektierten TMCC-Informationen und Kanalinformationen entsprechend aufgezeichnet werden.

6. Demodulator nach Anspruch 5,
ferner mit einer Fehlerkorrekturverarbeitungseinheit zur Fehlerkorrektur des demodulierten Signals auf der Basis der detektierten TMCC-Informationen.

7. Demodulator nach Anspruch 6,
bei dem die TMCC-Detektionseinheit angeordnet ist, um zu der Zeit der Kanalsuche TMCC-Informationen zu detektieren und zu der Zeit des normalen Empfangs TMCC-Informationen nicht zu detektieren, und
bei dem die Fehlerkorrekturverarbeitungseinheit angeordnet ist, um zu der Zeit des normalen Empfangs eine Fehlerkorrektur auf der Basis der aufgezeichneten TMCC-Informationen auszuführen.

8. Demodulator nach Anspruch 4,
ferner mit einer Aufzeichnungssteuereinheit zum Ausführen solch einer Steuerung, dass die detektierten TMCC-Informationen und Kanalinformationen entsprechend aufgezeichnet werden.

9. Demodulator nach Anspruch 8,
ferner mit einer Fehlerkorrekturverarbeitungseinheit zur Fehlerkorrektur des demodulierten Signals auf der Basis der detektierten TMCC-Informationen.

10. Demodulator nach Anspruch 9,
bei dem die TMCC-Detektionseinheit angeordnet ist, um zu der Zeit der Kanalsuche TMCC-Informationen zu detektieren und zu der Zeit des normalen Empfangs TMCC-Informationen nicht zu detektieren, und
bei dem die Fehlerkorrekturverarbeitungseinheit angeordnet ist, um zu der Zeit des normalen Empfangs die Fehlerkorrektur auf der Basis der aufgezeichneten TMCC-Informationen auszuführen.

11. Demodulator (102) mit:
einer Synchronisationsverarbeitungseinheit (115) zum Ausführen einer Synchronisationsverarbeitung auf der Basis eines Eingangssignals; und
einer Demodulationsverarbeitungseinheit (114) zum Ausführen einer orthogonalen Frequenzmultiplex-Demodulation auf der Basis des Synchronisationsverarbeitungssignals, und
bei dem die Demodulationsverarbeitungseinheit angeordnet ist, um die orthogonale Frequenzmultiplex-Demodulation auszuführen, wenn die Frequenzzuordnung eines Referenzsignals in dem Eingangssignal eine Bedingung erfüllt.

12. Demodulator nach Anspruch 11,
bei dem das Referenzsignal ein TMCC-Signal und/oder ein AC-(Auxialiary Channel)-Signal ist.

## Revendications

1. Démodulateur (102) comportant :
un filtre (112) pour filtrer un signal en fonction de bandes passantes de fréquences changées au moment d'une recherche de canal et au moment d'une réception normale ; et
une unité de traitement de démodulation (114) pour effectuer une démodulation par multiplexage par répartition en fréquence orthogonale en fonction du signal filtré, **caractérisé en ce qu'**il comporte en outre :
une unité de traitement de synchronisation (115) pour effectuer un traitement de synchronisation en fonction du signal filtré ;
une unité de traitement de synchronisation de trame (117) pour effectuer une détection d'un signal de synchronisation en fonction du signal démodulé ; et
une unité de détection TMCC (117) pour détecter une information de contrôle de configuration de la transmission et du multiplexage (TMCC) en fonction du signal démodulé lorsque le signal de synchronisation est détecté,
dans lequel ladite unité de traitement de démodulation (114) est agencée pour effectuer la démodulation par multiplexage par répartition en fréquence orthogonale en fonction du signal traité de synchronisation, et
dans lequel ladite unité de traitement de démodulation (114) est agencée pour effectuer la démodulation par multiplexage par répartition en fréquence orthogonale après le traitement de synchronisation lorsqu'une allocation de fréquence d'un signal de référence dans le signal filtré satisfait une condition.

2. Démodulateur selon la revendication 1, dans lequel l'information TMCC comprend une information d'un schéma de modulation de phase.

3. Démodulateur selon la revendication 2, dans lequel ladite unité de traitement de synchronisation est agencée pour calculer une valeur de corrélation d'un signal qui est un signal d'entrée retardé et le signal d'entrée, et pour effectuer le traitement de synchronisation lorsque la valeur de corrélation satisfait une condition.

4. Démodulateur selon la revendication 1, dans lequel le signal de référence est un signal TMCC et/ou un signal de canal auxiliaire AC.

5. Démodulateur selon la revendication 4, comportant en outre une unité de contrôle d'enregistrement pour effectuer un contrôle de sorte que l'information TMCC détectée et l'information de canal sont enregistrées de façon correspondante.

6. Démodulateur selon la revendication 5, comportant en outre une unité de traitement de correction d'erreur pour effectuer une correction d'erreur du signal démodulé en fonction de l'information TMCC détectée.

7. Démodulateur selon la revendication 6, dans lequel ladite unité de détection TMCC est agencée pour détecter une information TMCC au moment de la recherche de canal et pour ne pas détecter une information TMCC au moment de la réception normale, et
dans lequel ladite unité de traitement de correction d'erreur est agencée pour effectuer une correction d'erreur en fonction de l'information TMCC enregistrée, au moment de la réception normale.

8. Démodulateur selon la revendication 4, comportant en outre une unité de contrôle d'enregistrement pour effectuer un contrôle de sorte que l'information TMCC détectée et l'information de canal sont enregistrées de façon correspondante.

9. Démodulateur selon la revendication 8, comportant en outre une unité de traitement de correction d'erreur pour effectuer une correction d'erreur du signal démodulé en fonction de l'information TMCC détectée.

10. Démodulateur selon la revendication 9, dans lequel ladite unité de détection TMCC est agencée pour détecter une information TMCC au moment de la recherche de canal et pour ne pas détecter l'information TMCC au moment de la réception normale, et
dans lequel ladite unité de traitement de correction d'erreur est agencée pour effectuer la correction d'erreur en fonction de l'information TMCC enregistrée, au moment de la réception normale.

11. Démodulateur (102) comportant :
une unité de traitement de synchronisation (115) pour effectuer un traitement de synchronisation en fonction d'un signal d'entrée ; et
une unité de traitement de démodulation (114) pour effectuer une démodulation par multiplexage par répartition en fréquence orthogonale en fonction du signal de synchronisation traité, et
dans lequel ladite unité de traitement de démodulation est agencée pour effectuer la démodulation par multiplexage par répartition en fréquence orthogonale lorsqu'une allocation de fréquence d'un signal de référence dans le signal d'entrée satisfait une condition.

12. Démodulateur selon la revendication 11, dans lequel le signal de référence est un signal TMCC et/ou un signal de canal auxiliaire AC.
